# EUROPEAN PATENT SPECIFICATION

(11) **EP 0 555 368 B1**
(45) Date of publication and mention of the grant of the patent: **14.04.1999**
(21) Application number: 92900051.1
(22) Date of filing: 25.10.1991
(51) Int. Cl.: H01R 9/09

(54) **ELECTRICAL CONNECTORS HAVING TAPERED SPRING CONTACT ELEMENT**
ELEKTRISCHER VERBINDER MIT KONISCHEM FEDERKONTAKTELEMENT
CONNECTEURS ELECTRIQUES COMPRENANT UN ELEMENT FORMANT UN CONTACT A RESSORTS CONIQUE

(30) Priority: 29.10.1990 US 605523
(43) Date of publication of application: 18.08.1993
(73) Proprietor: General DataComm, Inc., Middlebury CT 06762-1229 (US)
(72) Inventor: REYMOND, Welles, K., Waterbury, CT 06705 (US); SORRENTINO, Gregory, L., Brewster, NY 10509 (US)
(74) Representative: Gibson, Stewart Harry
(86) International application number: US9108009
(87) International publication number: WO9208258

(56) References cited:
- DE-U- 8 706 546
- US-A- 3 899 231
- US-A- 4 528 500
- IBM Technical Disclosure Bulletin, Volume 6, No. 10, issued March 1964, H.C. SCHICK, Plated Through-Hole Contact.

## Description

This invention relates generally to electrical connectors. More particularly, the invention relates to an electrical connector which utilizes the mating of a tapered contact element with the conductive rim of a hole for providing an electrical connector function. The invention further relates to electrically connecting a first board, cable, wire, or other current carrying means which is coupled to the contact element, to a second board, cable, wire or other current carrying means on which the conductive rim of the hole is located.

The electrical connector arts are crowded arts, with many categories and subcategories of connectors. Known connectors include ribbon cable connectors, flex circuit connectors, pin and socket connectors, rack and panel connectors, zero insertion force connectors, coaxial cable connectors, insulation displacement connectors, quick connect/disconnect connectors, card edge connectors, board to board connectors, board to wire connectors, surface mount connectors, etc. Common to many of the connectors is that they include a male component which is coupled to a first device which is to be connected and a female component which is coupled to a second device which is to be connected, wherein the male and female components are arranged to mate. While two piece (i.e. male and female component) connectors are generally effective for their purposes, they are costly because they require two separate parts for accomplishing a single connection. In addition, where the connectors have multiple pins, connection and disconnection becomes difficult because of the forces involved, and the male connector is easily damaged during removal or reinsertion. Also, because a connector piece is required on each of the devices to be connected, the two piece connectors often take up valuable space.

IBM Technical Disclosure Bulletin, Vol. 6, No. 10, 1964 discloses an electrical connector for mating with conductive rims of holes of a circuit board. The connector comprises a plurality of contact element within a housing. Each contact element has a tapered contact portion, tapered along an axis of the contact element, for mating with one of the conductive rims of the circuit board, and a spring portion coupled to the tapered contact portion and making electrical contact (via another tapered contact portion) with a second circuit board.

US-A-3,899,231 discloses an electrical connector having a contact element formed with a tapered contact portion which engages within, and against the side walls of, a plated aperture in a circuit panel.

US-A-4528500 discloses an apparatus for locating a pin board with respect to a matrix testing jig in a test fixture for printed circuit boards. The apparatus includes a set of spring-loaded pins which are constrained against lateral movement. DE-U-8706546 discloses a similar testing apparatus for printed circuit boards, in which the spring-loaded pins are laterally displaceable.

In accordance with the present invention, there is provided an electrical connector for mating with conductive rims of holes of a circuit board, the electrical connector comprising a plurality of contact element means and a housing which houses the plurality of contact element means, each contact element means having a tapered contact portion for mating with one of the conductive rims of the circuit board, said tapered contact portion being tapered along an axis of its contact element means, and a spring portion which is coupled to the tapered contact portion, makes electrical contact with a conductor means other than said circuit board with which the tapered contact portion makes contact, and urges the tapered contact portion along its said axis, characterized in that each contact element means is laterally tolerant for permitting said tapered contact portion to move in said housing in a direction which is lateral with respect to said axis of its contact element means so as to seat in the conductive rim of the hole in the circuit board with which it mates, and said electrical connector further comprises fastening means for fastening said electrical connector to the circuit board to keep said plurality of tapered contact portions mated with said conductive rims.

Each aspect of the invention may take many forms. The spring portion of the contact elements may have, e.g., a u, s, or z shape. The tapered contact portion of the contact elements can take the form of a bifurcated cone or a compliant bent wire. Also, the portion of the contact elements which make electrical contact with the first object may take the form of, e.g., a post for coupling to holes, prongs for stripping insulation, a spring for surface contact, or any of many tapered forms such as described with reference to the tapered contact portion for coupling to conductive rims. the housing for the tapered contact elements may be arranged to serve various purposes. For example, by making the wall section of the housing through which the contact elements extend nonuniform, a "first make, last break" function can be accomplished. A "first make, last break" function may also be accomplished by a hinged housing. Also, the housing for the contact elements may be one piece or two piece, rear loaded or front loaded.

Other objects and advantages of the present invention will become evident upon reference to the detailed description in conjunction with the provided figures.

### BRIEF DESCRIPTION OF THE DRAWINGS.

Fig. 1 is a perspective view of a column section of a first embodiment of the connector invention prior to insertion of a preformed spring contact elements into the housing.
Fig. 2a is a top view of the first embodiment of the connector invention showing a row of contact elements with second ends extending appropriately out of the housing.
Fig. 2b is a front view of the first embodiment of the connector invention.
Fig. 3a is a cross sectional view of the first embodiment of the connector invention through line A-A of Figure 2b.
Fig. 3b is an enlarged cross sectional view of the self-centering tapered funnel of the housing shown in Fig. 3a with a contact element located therein in an unengaged extended position, and in engaged depressed positions.
Fig. 3c is a partially cut-away top view of the connector of Figure 3a taken along line C-C of Fig. 3a.
Fig. 4a is a perspective enlarged view of the tapered end of a single split-cone contact element in contact with a plated through hole.
Fig. 4b is a cross sectional view of the tapered end of a single split-cone contact element of the first embodiment of the connector through line B-B of Fig. 4a.
Fig. 4c is a force diagram for a typical contact element of the connector of the invention, showing both axial insertion (hold-in) and mating contact normal forces.
Figs. 5a-5f are diagrammatic representations of six different embodiments of the spring portion of the contact element of the invention;
Fig. 5g is an exploded view of a second embodiment of the connector invention having a housing and utilizing the contact of Fig. 5f;
Fig. 5h is a partial cross-sectional view of the assembled connector of Fig. 5g;
Fig. 6a-6d are diagrammatic representations of four different embodiments of the tail portion of the contact element of the invention;
Fig. 6e is a cross section through a connector according to the invention utilizing the contact element of Fig. 6a;
Figs. 6f-6h are exploded views of different connectors according to the invention utilizing the contact element of Fig. 6b;
Figs. 6i and 6j are cross sections through connectors of the invention utilizing the contact elements of Fig. 6d;
Figs. 7a and 7b are front and side views of a wire tip embodiment of the contact element of the invention;
Fig. 8 is a cross-section through a connector of the invention utilizing a wire formed contact element, where the housing of the connector is used as a mandrel for the forming of the spring loaded contact element;
Fig. 9 is a cross section through a housing for a connector of the invention having a first make, last break feature formed by the housing itself;
Fig. 10 is a diagrammatic perspective of a connector of the invention utilizing a hinged housing;
Figs. 11a and 11b are cross sections through a straight through embodiment and a perpendicular embodiment of a female mating connector for the connector of the invention;
Figs. 12a and 12b are cross sections through non-solder straight and right angle permanent connectors respectively;
Figure 13 is a cross section of a flex-print to board connector utilizing the tapered contact to conductive rim mating according to the invention; and
Figure 14 is a cross section of a connector useful for board to board applications where different board to board distances are accommodated.

### DETAILED DESCRIPTION OF THE PREFERRED EMBODIMENT

Before describing the preferred embodiments of the invention, it should be appreciated that the connector invention as described herein is for mating with the conductive rims of the holes of an object. The holes need not be round, as connection to rims of other shaped holes (even if the rim is not continuous) is envisioned. Neither must the holes be through holes or plated through holes, as connections with blind holes or holes having only a plated rim are envisioned. Further, the object in which the holes are located need not be a printed circuit board, as connection to other objects (e.g., flex circuits) is envisioned.

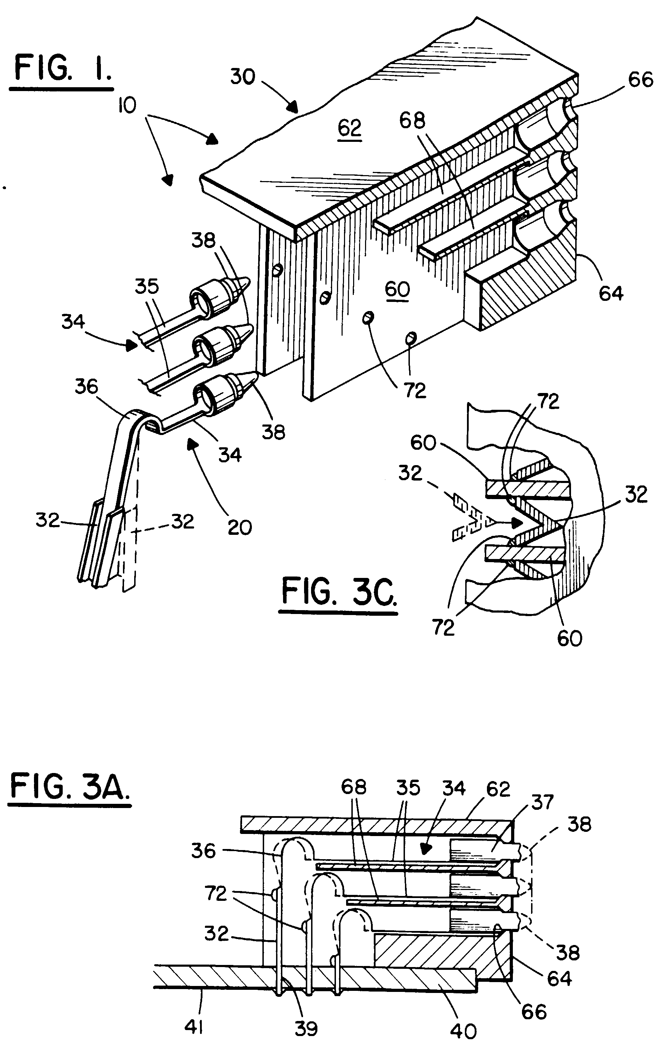

Figures 1, 2a, 2b, 3a - 3c, and 4a - 4c show a first connector embodiment of the invention which is a right angle connector. The connector assembly 10 typically comprises a plurality of contact elements 20, and a dielectric housing 30 for housing the contact elements. The contact elements 30 are spring pins with first ends 32, second ends 34, and a middle bend section 36. The first ends 32 of pins 20 extend through holes 39 in a daughter board 40 and are preferably soldered to the back side 41 of the daughter board. At least a portion of the first ends 32 is preferably v-shaped to help align the first ends in the holes 39 of the daughter board 40. The shape of first ends 32 also provides stiffness, and helps in preloading the contacts as will be discussed hereinafter.

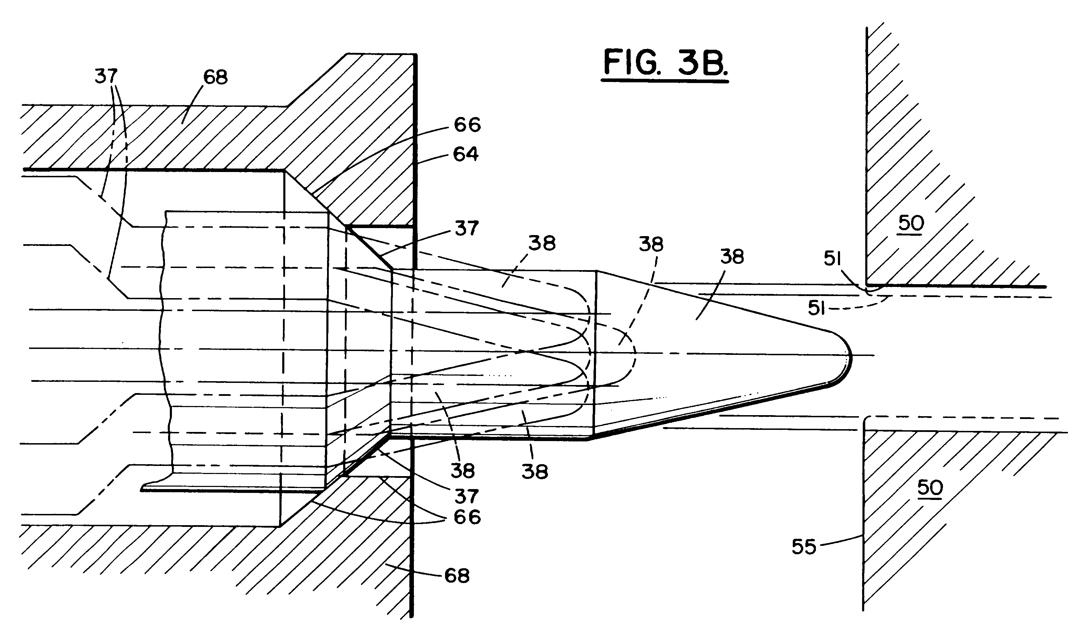

The second ends 34 of the contact elements 30 are basically comprised of a neck portion 35 which may be channel shaped for stiffness, and a tapered contact portion 38. As seen in Fig. 3b, connecting the neck portion 35 to the contact portion 38 is an angled portion 37 which acts in conjunction with the housing to provide self-alignment and preloading as will be described hereinafter.

The mid-sections 36 of pins 20 are preferably crimped to cause pins 20 to form a spring. As shown in Fig. 1, pins 20 are preferably crimped to first form a one hundred eighty degree bend and then a minus ninety degree bend, and are thus essentially bent through ninety degrees. If desired, a simple bend of ninety degrees could be used, provided mid-sections 36 form spring elements. As seen in Fig. 3a in phantom, when contact portions 38 of second ends 34 of pins 30 engage the mother board 50, the mid-sections 36 resiliently deflect away from the mother board 50; i.e. the mid-sections 36 are compliant along the mating axis. In so doing, the mid-sections 36 provide pins 30 with a mating force.

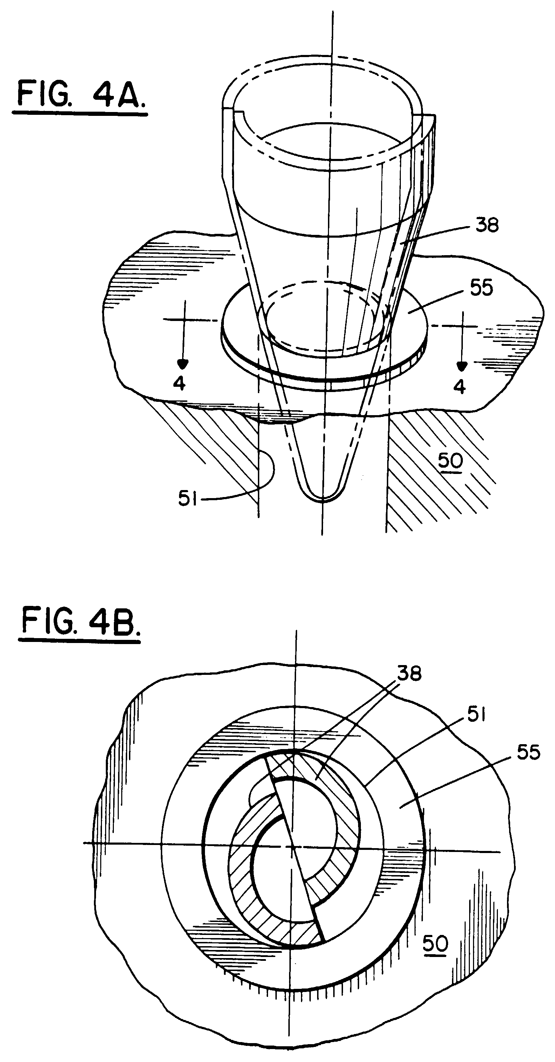

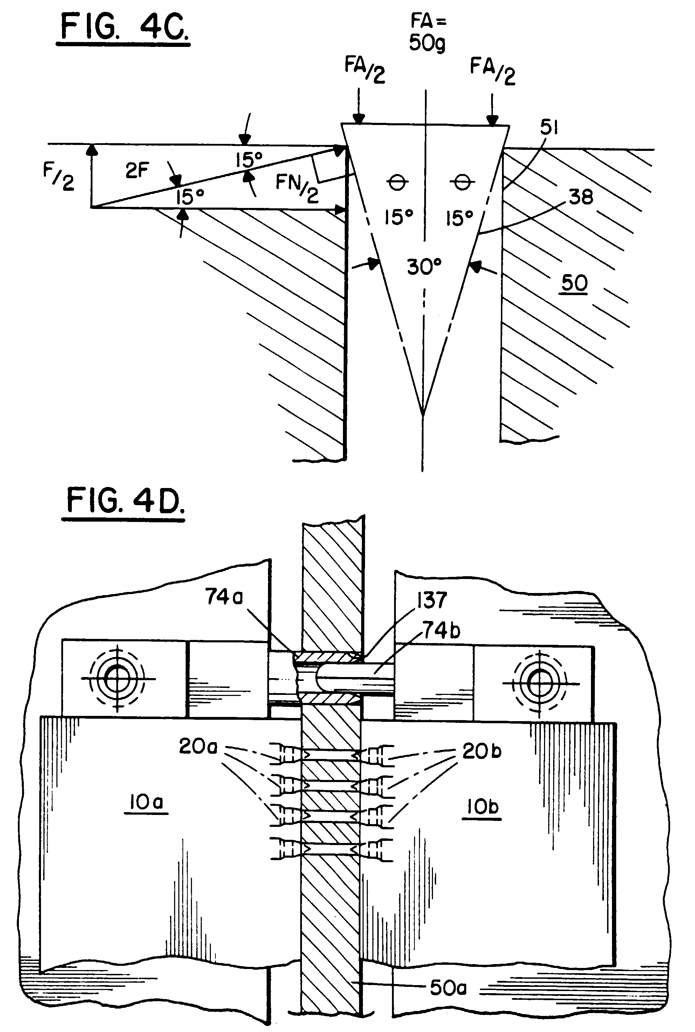

As seen in Fig. 4a, the contact portions 38 of the second ends 34 of contact elements 20 are tapered in cross section, with the cross section becoming larger further away from the end or tip of the contact element. The contact portions 38 are used to make contact with the plated through holes 51 of the mother board 50. Where the contact portions 38 of the second ends 34 are the preferred split (bifurcated) cones (as seen in Figs. 4a and 4b), contact is made between the connector 10 and the mother board 50 at two points 53a, 53b (radius contact "points") for each contact element 20 and through hole 51. The contact is made between the tapered portion (i.e. the contact portion 38) of the contact element 20 and the rim of hole 51; i.e. the circumference of the hole 51 at the surface 55 of the mother board 50. In making contact, because contact portion 38 is bifurcated, it resiliently compresses as it is pushed into hole 51, and therefore extends into hole 51 further than it might have otherwise. As a result, the surface of contact portion 38 wipes along the rim of hole 51 as it makes contact providing desired "wipe" and enhanced contact.

As seen in idealized force diagram of Fig. 4c, the use of contact elements having tapered contact portions 38 which extend into plated through holes 51 of a mother board magnifies the "normal" force relative to the axial holding or mating force. In particular, and by way of example only, if the axial mating force F_{A} is fifty grams, the axial mating force at each of the two points of contact is seen as twenty-five grams (F_{A}/2). Of course, the mother PCB must assert an equal but opposite force of twenty-five grams at each point. However, the equal but opposite force must be asserted as a component of a force which is perpendicular (i.e. normal) to the point of contact. Thus, at each of the two contact points, the mother board 50 provides a normal contact force F_{N}/2 (shown as the hypotenuse of the triangle). Each normal contact force is the result of two perpendicular forces; an axial force of twenty-five grams opposite to the mating force (as required to provide an equal but opposite force to the axial mating force); and a force perpendicular to the axial force. As will be appreciated, the perpendicular forces to the axial forces are equal and opposite each other and therefore cancel.

Assuming that the contact portion 38 tapers at an angle of fifteen degrees relative to the axial direction, in order for a twenty-five gram axial force opposite to the axial mating force to be generated at each point of contact, a resultant normal force (F_{N}/2) of one hundred grams (twenty-five grams divided by the sine of fifteen degrees) is generated at each point. Thus, for a pin having a total axial mating force of fifty grams, the normal force generated is two hundred grams. More generically, the normal force generated at each point of contact is equal to the axial force at that contact point divided by the sine of the taper angle of the tapered contact portion 38 of the pin 20. The smaller the taper angle , the larger the normal force generated. Regardless of the taper angle, the total normal force generated by all the contact points is always greater than the axial insertion force as F_{N}/F_{A} = 1/sin.

Returning to Figs. 1, 2a, 2b, and 3a-3c a single piece dielectric housing 30 is seen. The housing 30 includes side walls 60 which separate and electrically insulate each column of contact pins 20; the side walls 60 extending perpendicularly from top wall 62. Also extending perpendicularly from top wall 62 is front wall 64 having a plurality of openings 66 for permitting at least a portion of tapered contact portions 38 (and preferably the entire tapered contact portion) of contact pins 20 to extend therethrough. Openings 66 are preferably tapered funnels which are arranged to interact with the angled portion 37 of the second ends 34 of the contact pins as will be hereinafter described. Extending rearward from the front wall 64 in a manner parallel to top wall 62 are a plurality of pin separation walls 68 (also called "guide walls") which guide the second ends 34 and contact portions 38 of pins 20 into their preloaded position, and electrically insulate one pin contact from another. Because different rows of pins 20 traverse different lengths (as seen in Figs. 1 and 3a), the lengths of separation walls 68 are varied accordingly. Preferably, each guide wall extends slightly past the middle bent portion 36 of the pin contact below it, but only as far as the second end 34 of the pin above it.

Fig. 3b explores the axial and lateral tolerances built into the connector contact pins relative to the holes of the mother board. As shown, when the contact pins are not engaging the mother board, angled portions 37 contact the funnel-like openings 66 and thereby center themselves therein in a nominal position. By arranging openings 66 to be smaller in cross section than the cross section of the widest part of angled portion 37, the openings 66 act as a stop to the contact spring pins 20 to cause the spring pins to be preloaded in the housing, as will be discussed hereinafter. In the preloaded position, the contact portions 38 of the pins 20 extend out of the housing 30 by a desired amount. When the contact pins 20 engage the mother board holes, the pins 20 are pushed backward (as seen in phantom) such that the angled portion 37 of the second ends 34 of the pins no longer contacts the funnel-like openings 66 of the housing 30. As a result, lateral movement of the second end of the pin is expedited in all directions, as the passage for the second end of the pin defined by adjacent side walls 60 and adjacent guide walls 68 of the housing 30 is wider than the second ends 34 of the pins. As will be appreciated by those skilled in the art, the further pins 20 are pushed backward, the more second ends 34 can move laterally in any direction in the housing passage. As a result, a tolerance zone or range for the misalignment of a pin relative to a hole is provided which can approach the radius of the hole in size (provided the housing passage and funnel-like opening are large enough). Also, as seen in Fig. 3b, the tapering of the contact portion 38 of pin 20 provides tolerance relative to the hole diameter, as contact along the tapered surface of the contact portion 38 is guaranteed.

As seen in Figs. 1, 3a, and 3c, side walls 60 of housing 30 preferably include sidewall locking tabs 72 (preferably two per contact) which hold adjacent rows of contacts in a preloaded manner at different fixing points relative to the daughter board 40 but at identical fixing points relative to the ninety-degree bend portion 36 of the contact elements 20. The locking tabs 72 provide a restriction between adjacent side walls 60 through which the v-shaped first end 32 of pins 20 are forced during assembly. After the v-shaped first end 32 deforms and passes through the tabs 72, they cannot return past the tabs 72. Thus, locking tabs 72 act to provide a preload to the spring contact elements 20 as the spring contact elements 20 are fixed in location on one end by the contact of angled portion 37 with the funnel-like opening 66, and on the other end by locking tabs. The locking tabs 72 also act to establish a fixing point which fixes a portion of first end 32 (the portion between the locking tab 72 and the daughter board) against movement in the axis of insertion. As a result, the tabs 72 act as a strain relief for the first end 32 - daughter board solder joint, as the first end 32 will not substantially move below tab 72. The v-shape of first end 32 also helps to stiffen first end 32 and to prevent movement at the solder joint.

By locating the locking tabs 72 such that pins of different rows have approximately the same spring length between the fixing point and the bend (as seen in Figs. 1 and 3a), equal bearing forces between the contact portions 38 of pins 20 of different rows of the connector and the holes 51 of the mother board 50 are assured.

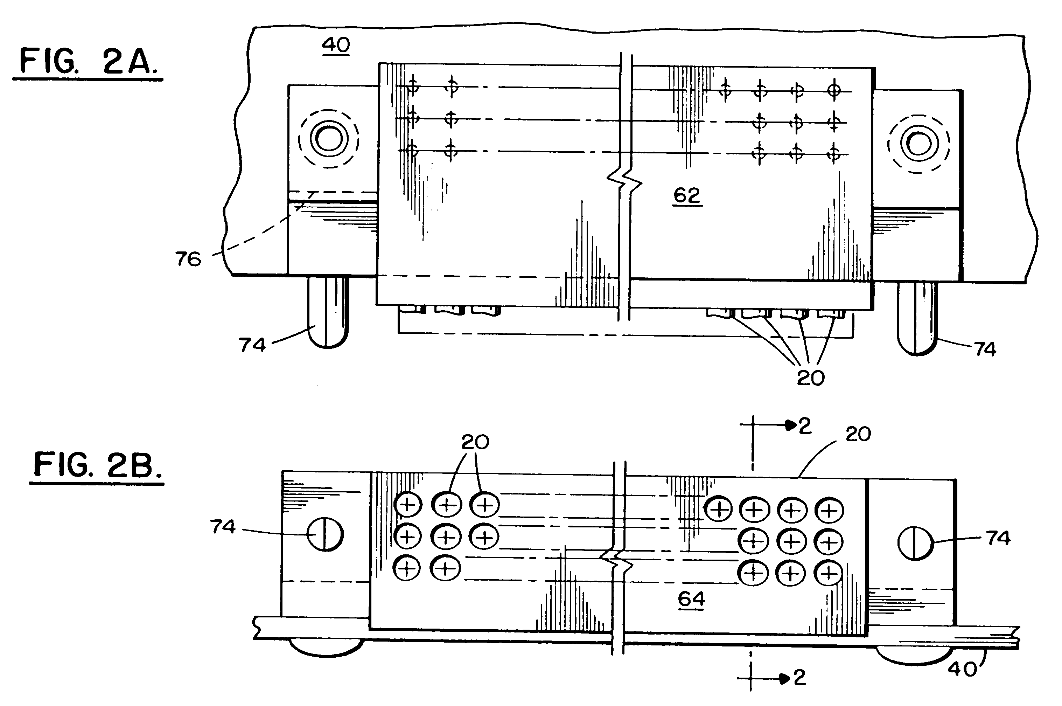

Housing 30 may also include at least one integral guide pin 74. Guide pin 74 may act as a ground pin by having a ground wire (not shown) wrapped around it, and/or a make first pin for the connector. Typically, and as shown in Figs. 2a and 2b, two guide pins 74 are located on either end of the connector and extend along the same axis as the second portion of pins 20. Preferably, the guide pins extend out further than the contact portions 38 of pins 20 and thus act in a shielding or protective capacity, although other protective means such as retractable shrouds (e.g. live hinges or protective flaps) could be utilized. The guide pins 74 are preferably arranged such that they extend into mating holes in the mother board, with the diameter of the mating holes being as large as or slightly greater than the diameter of non-tapered section of the guide pin. While at least one guide pin is preferably integrally molded with the connector, other guide pins may have a threaded end, and are held in place in the housing 30 by rivets 76. If desired, first and second guide pins may be oval in cross-section and oriented perpendicularly with respect to one another. In this manner, one guide pin acts as a horizontal guide, while the other acts as a vertical guide.

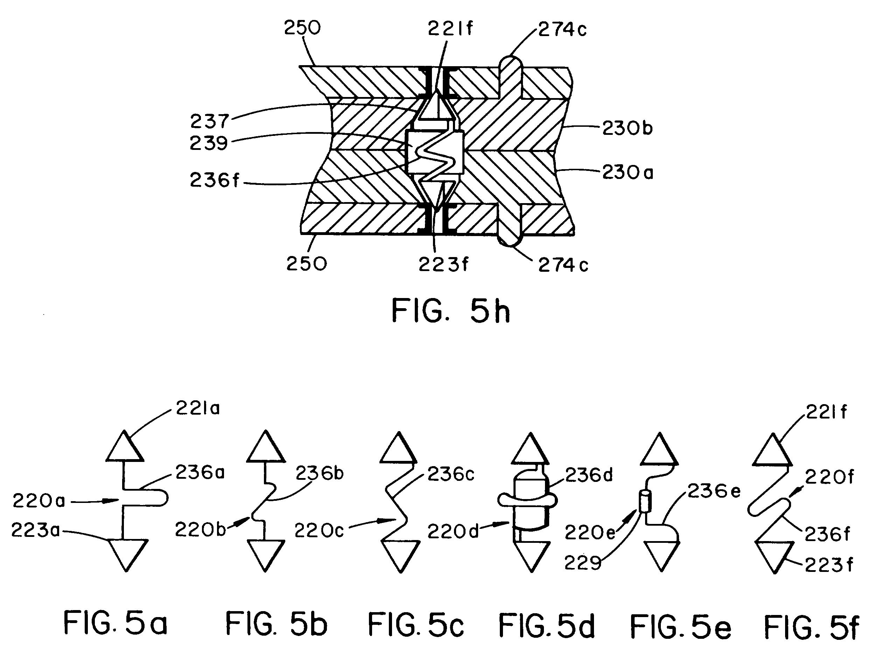

Turning to Figures 5a-5f, six different spring contact elements 220a, 220b,... which are useful for parallel board to board connectors are seen. Each of the spring contact elements 220 has a first tapered end 221, a middle portion 236, and a second tapered end 223. The tapered ends 221 and 223 are used to mate with the conductive rims of a board. The middle portions 236 of each of spring contact elements 220a, 220b,... effectively provide the spring action when the spring contact elements are loaded in a housing. The middle portion 236a of spring element 220a of Fig. 5a is a u-shaped spring, while the middle portion 236b or spring element 220b of Fig. 5b is a z-shaped spring. The z-shaped spring provides some symmetry as opposed to the u-shaped spring. Middle portions 236c and 236f of spring elements 220c and 220f are s-shaped springs which also provide symmetry. In addition, with the severe s-shape of spring element 220f, when tapered ends 221f and 223f are pressed together, the s-shaped middle portion 236f actually decreases in width rather than increasing as would be the case with the spring elements of Figures 5b and 5c.

The middle portion 236d of spring element 220d of Fig. 5d is a bellows (i.e. a continuous u-shaped spring) which has low inductance and hence a different electrical characteristic than the other spring elements. The middle portion 236e of spring element 220e of Fig. 5e, is formed by welding the tails of two identical single tapered elements together at weld 229. With spring element 220e, the connection of parallel boards having different spacings can be accommodated with a single contact element tooling, as the tails may be welded at different points to form spring elements of different lengths. It should be appreciated that the locations of joining of the tapered ends 221 and 223 to the middle portion 236 in each of the spring elements of Figs. 5a-5e are preferably chosen to provide the most stability for the spring element; i.e. to reduce torque to a minimum when the tapered portion mates with a rim.

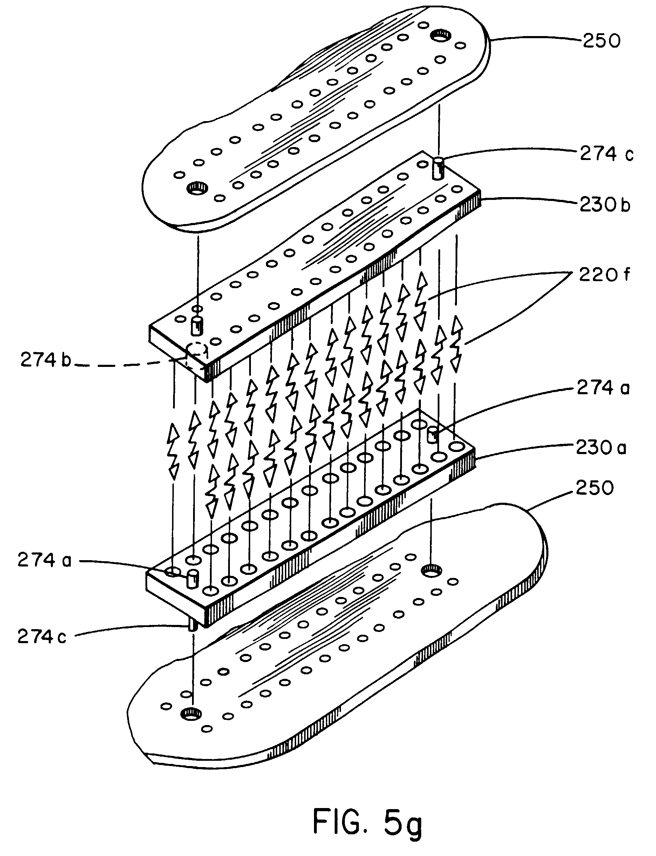

Turning to Figures 5g and 5h, a connector with a plurality of spring contact elements 220f and a two piece housing 230 is seen. As seen in more detail in Fig. 5h, each piece 230a and 230b of housing 230 has a plurality of holes in which the tapered contact and the middle portion of the spring is housed. In particular, the holes of the housing are comprised of a tapered section 237 through which the tapered contact (221 or 223) extends, and a larger opening 239 in which the s-shaped spring 236f is housed. Enough room is provided in opening 239 to guarantee that the s-spring 236f will not touch the housing in its preloaded and mating positions. Pieces 230a and 230b of housing 230 may be identical, assembled back-to-back, and held together via sonic welding, glue, or other means. On the other hand, if desired, pieces 230a and 230b may be provided with reciprocating posts 274a and post receivers 274b for a friction or press fit. Regardless, the housing 230 preferably includes posts 274c which act as guide pins for mating with circuit boards 250.

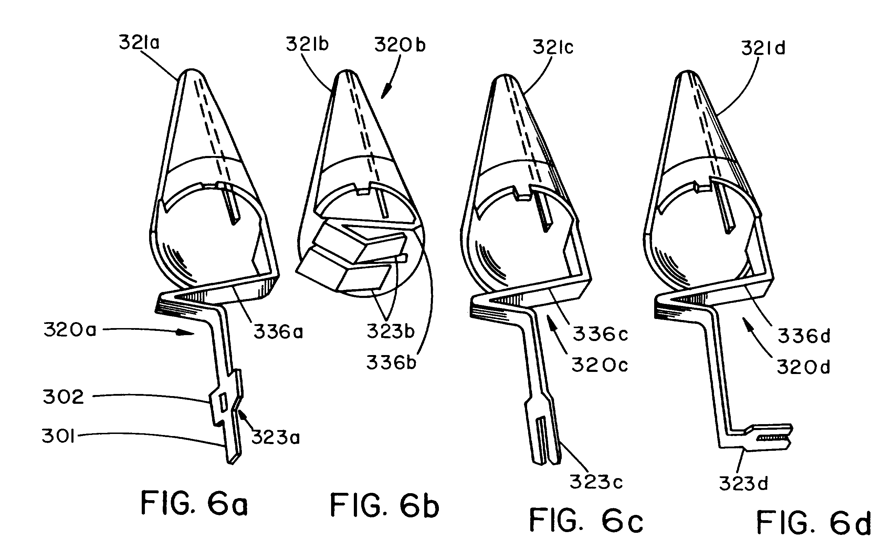

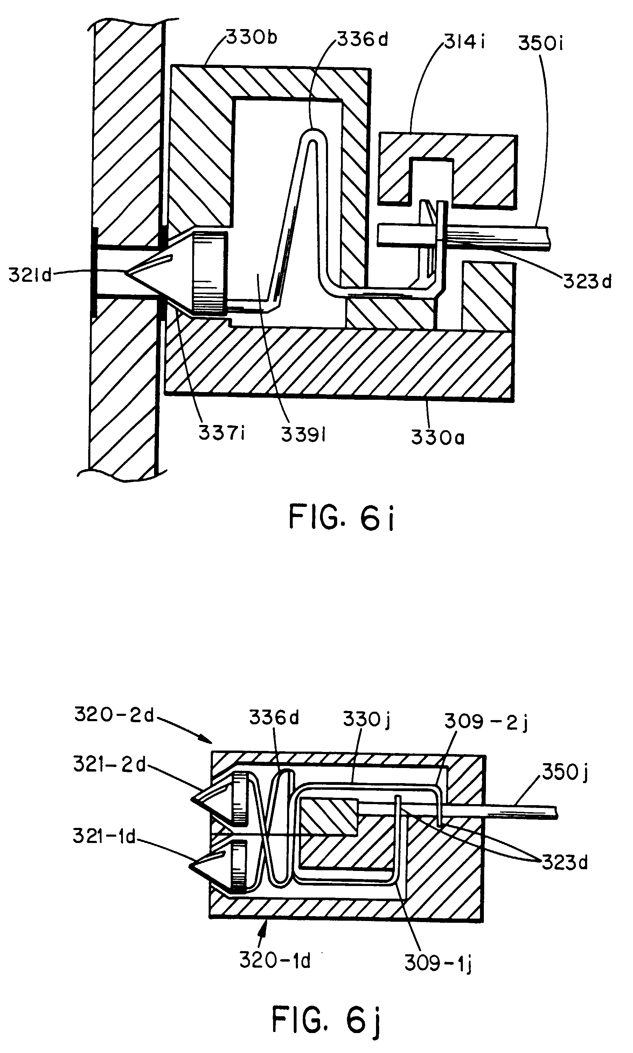

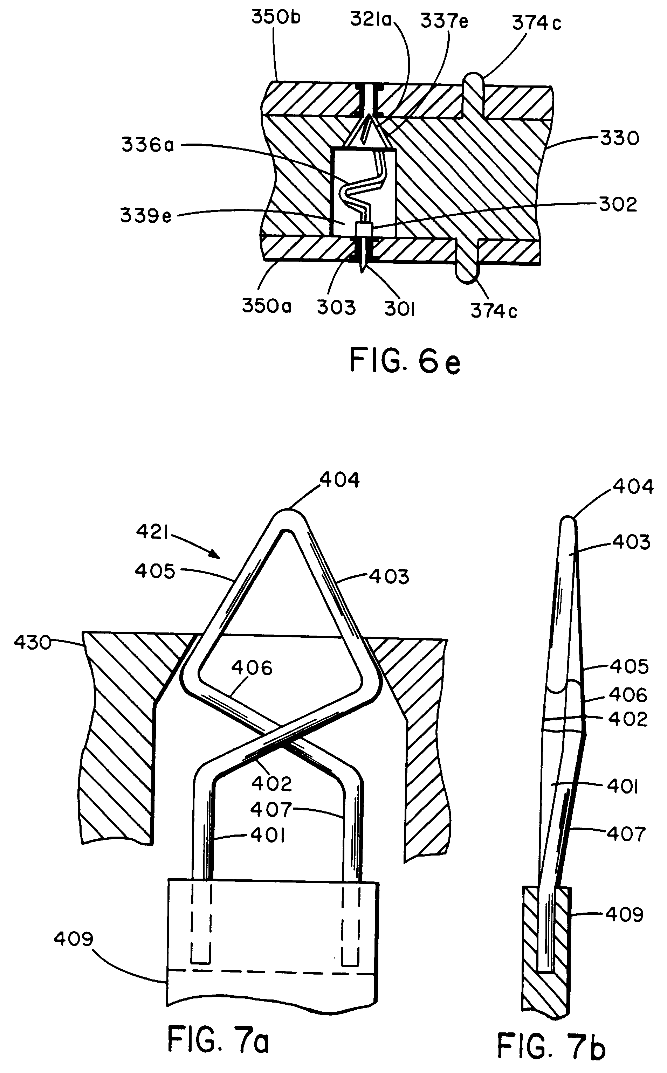

It should be appreciated that the spring contact elements of Figs. 5a-5f may be provided with two tapered ends for tapered-end-to-rim mating with holes of two boards, or may be provided with one tapered end for tapered-end-to-rim mating and a second end (tail portion) with a different configuration for connection or mating to any desired conductive device. Examples of spring contact elements with different tail portions are seen in Figs. 6a-6d. In Fig. 6a, a spring contact element 320a is shown with a tapered contact portion 321a for mating with the conductive rim of a hole in circuit board 350b, a spring portion 336a, and a tail portion 323a. The tail portion 323a includes a solder tail 301 and a stop 302, with the tail 301 being arranged to be press fit and/or soldered into a hole 303 (as seen in Fig. 6e) of circuit board 350a, or surface mounted (SMT) on the board surface. The connector utilizing the contact 320a, as seen in Fig. 6e, has a one piece housing 330 with a tapered opening 337e for the tapered contact portion 321a, and an opening 339e of slightly larger width for housing the spring 336a. Guide pins 374c are provided for mating with holes in circuit boards 350a and 350b.

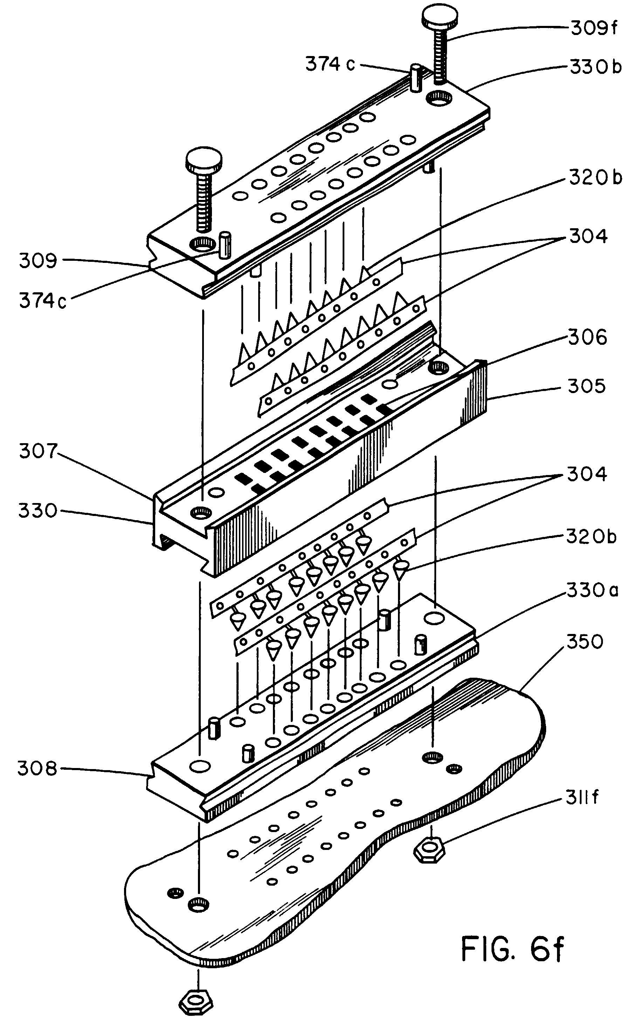

The spring contact element 320b of Fig. 6b, also includes the tapered contact portion 321b, a spring portion 336b, and a tail portion 323b. However, the tail portion 323b is effectively part of the spring portion 336 and provides preloading to establish electrical contact with a conductive pad, wire, or surface. The tail portion 323b may be a single piece or bifurcated as shown in Fig. 6b. Spring contact element 320b is easily formed and plated on a carrier strip (shown in Figs. 6f-6h) which may be broken away when the tapered contact portion 320b is inserted into a suitable housing 330.

As seen in Figs. 6f-6h, the spring contact element 320b is advantageously used in several different manners. In Fig. 6f, a connector which can connect two aligned circuit boards is shown. The connector includes two sets of tapered contact elements 320b (shown with their carrier strips 304 which are removed upon loading), a spacer 305 with conductive pads or wires 306, and a housing 330 having pieces 330a and 330b. The spacer 305 is provided with shaped rails 307, and the housing pieces 330a and 330b are provided with grooves 308 for permitting housing pieces 330a and 330b to be snapped into spacer 305 to form a unitary assembly. If desired, the connector housing and spacer as well as the circuit board 350 may be provided with holes to permit the connector to be attached to the circuit board via screws 309f and nuts 311f. Guide pins 374c may also be provided. When loaded, the tails 323b of contact element 320b are in contact with different wires or pads 306 of the spacer 305. The spacer 305 includes internal connective wires to electrically connect each pad 306 on one side of the spacer to one or more associated pads on the other side of the spacer. The spacer 305 may be manufactured to different thicknesses to accommodate different board to board spacings.

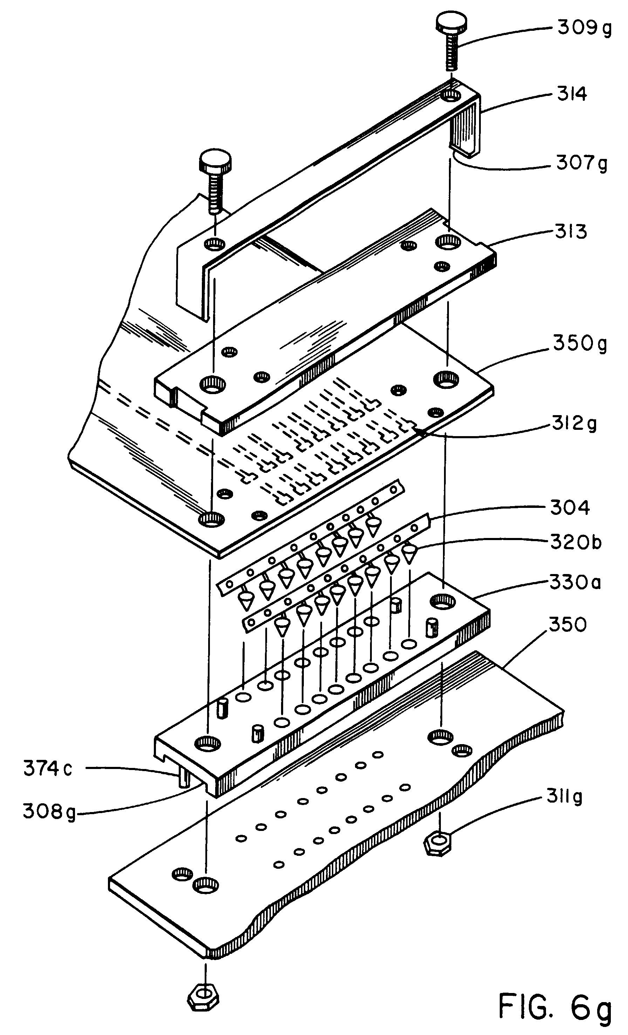

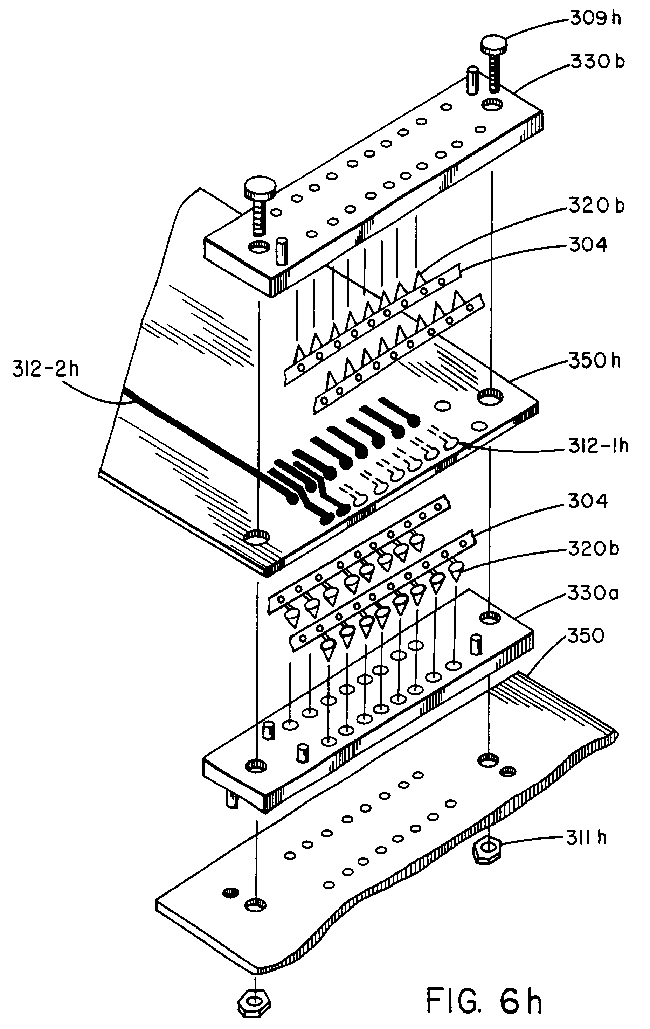

Figs. 6g and 6h show the spring contact element 320b used in a PC board to surface mount board connector and in a PC board to flex circuit connector. In Fig. 6g, the surface mount board 305g having bottom side circuit pads 312g is included in the connector by providing a plastic strain relief piece 313 and a metal clip 314 which sit atop the the SMT board 305g and are held by nuts 311g and screws 309g which extend therethrough and through the housing 330a and PC board 350. The metal clip 314 is provided to maintain flatness and contact force. Rails 307g on the metal clip 314 grab grooves 308g on the housing 330a for a snap fit.

As seen in Fig. 6h, a flex circuit 350h, which includes top and bottom pads 312-1h and 312-2h, is incorporated into a connector. The connector of Fig. 6h also includes two sets of contact elements 320b carried on carrier strips 304, housing pieces 330a and 330b. When the contact elements 320b are placed in the housing, 330, the carrier strips are preferably removed. The entire assembly is fastened with screws 309h and nuts 311h in a similar manner to the assemblies of Figs. 6f and 6g.

Turning to Figs. 6c and 6d, contact elements 320c and 320d which have tail portions adapted for ribbon cable connection (i.e. insulation displacement) are seen. The contact elements 320c and 320d are substantially identical, except that the tail portion 323c of Fig. 6c is substantially coaxial with the contact portion 321c, while the tail portion 323d of Fig. 6d is substantially perpendicular to the contact portion 321d.

In Figs. 6i and 6j, the contact element 320d shown in Fig. 6d is used in two different configurations for two different connectors. In Fig. 6i, a two piece housing (330a, 330b) is utilized to house contact element 320d, having contact portion 321d, spring portion 336d, and tail portion 323d. The tail portion 323d is perpendicular to the contact portion and has two prongs which act to strip insulation from a ribbon cable 350i. A clamp 314i is provided to guarantee permanent engagement between the ribbon cable 350i and the tail portion 323d of the contact element 320d.

In Fig. 6j, two identical contact elements 321-1d and 321-2d are provided with one of the elements rotated one hundred eight degrees relative to the other, and with the elements having their tail portions 323d bent at different locations (309-1j and 309-2j). With such an arrangement, the insulation stripping tail portions of the adjacent contact elements are not directly adjacent each other; the non-adjacency of contacts between wires of a ribbon cable being a requirement for most ribbon cable connectors due to the proximity of the wires.

Turning to Fig. 7a, a tapered contact element 421 made from wire is seen in a housing 430 with an opening. The tapered contact element 421 is effectively bifurcated with segments 401, 402 and 403 acting as a first portion, and segments 405, 406, and 407 acting as a second substantially independent portion. Segment 401 of the tapered contact element is anchored in a supporting post, and segment 402 is bent at an angle of about one hundred twenty degrees relative to segment 401. Segment 403 is bent at an angle of approximately ninety degrees relative to segment 402 and terminates at point 404 where the second portion of the tapered contact element 421 also terminates. The relative geometries of segments 407, 406 and 405 mirror those of segments 401, 402, and 403. However, as seen in Fig. 7b, the bending of segment 402 relative to segment 401, and segment 406 relative to 407 is slightly different (i.e. opposite) in a second plane such that segments 402 and 406 can extend past each other. As seen in Fig. 7a, segments 402 and 406 touch each other as they extend past each other, although such touching is not required. Likewise, in order that segments 403 and 405 meet at point 404, the bending of segment 403 relative to segment 402 in a second plane is the opposite of the bending of segment 405 relative to segment 406 in that second plane.

With the wire formed tapered contact element 421, the tip 404 has three degrees of freedom. When segments 403 and 405 make contact with the rim of a hole, segments 403 and 405 are pushed backward, causing the angles between segments 401 and 402, segments 407 and 406, segments 402 and 403, and segments 405 and 406 to be decreased, and the angle between segments 403 and 405 to be increased. Thus, when the wire formed tapered contact element 421 engages the rim of a hole, the tapered portion in part compresses and in part retracts and enhances contact. In addition, some rotation of the contact element 421 relative to the rim of the hole can occur which further enhances contact. Effectively, then, because wire formed tapered contact element 421 has a tip which has flexibility in several directions, the tip may act both as the contact portion and the spring portion of the contact element. No spring section is required for contact element 421 beyond the contact portion, although a spring section may be used.

It will be appreciated that the wire formed tapered contact element may be provided with different post assemblies. For example, the segments 401 and 407 can be crimped in a split post 409 as seen in Fig. 7a, force fit or soldered to a post having holes therein, welded to the outside of a round or square post, etc.

It will further be appreciated that depending on the properties of the wire of the wire formed tapered contact element 421 of Figs. 7a and 7b, and also depending upon the angles between the segments themselves, and the angle between segments 401 and 407 and the post 409, the wire formed tapered contact element 421 may be primarily radially compliant as opposed to being primarily axially compliant like the tapered contact elements of Figs. 3a, and 5a-5f. In other words, with the arrangement shown in Figs. 7a and 7b, when the wire formed tapered contact element 421 contacts the rim of a hole, point 404 (the tip) of the contact element moves back very little, as opposed to the point of the bifurcated spring contact portion of Fig. 3a. Rather, the angle between segments 403 and 405 changes so that the segments 403 and 405 (which effectively form a cross section through a tapered cone) are compressed while they ride down the hole. The compression of the "cone" provides a high degree of wipe during mating. In Fig. 3a, there is more axial compliance and less radial compliance (although the bifurcated cone is radially compliant), and as a result, there is less wipe. Thus, depending upon the particular circumstances, it may be desirable to use a connector having a wire formed tapered contact element such as in Figs. 7a and 7b, or a contact element such as in Figs. 3a, and 5a-5f which provide more axial compliance. It should be noted, that regardless of the degree of axial versus radial compliance desired, lateral compliance in the contact element is also desired to give alignment tolerance between the contact element and the hole rim.

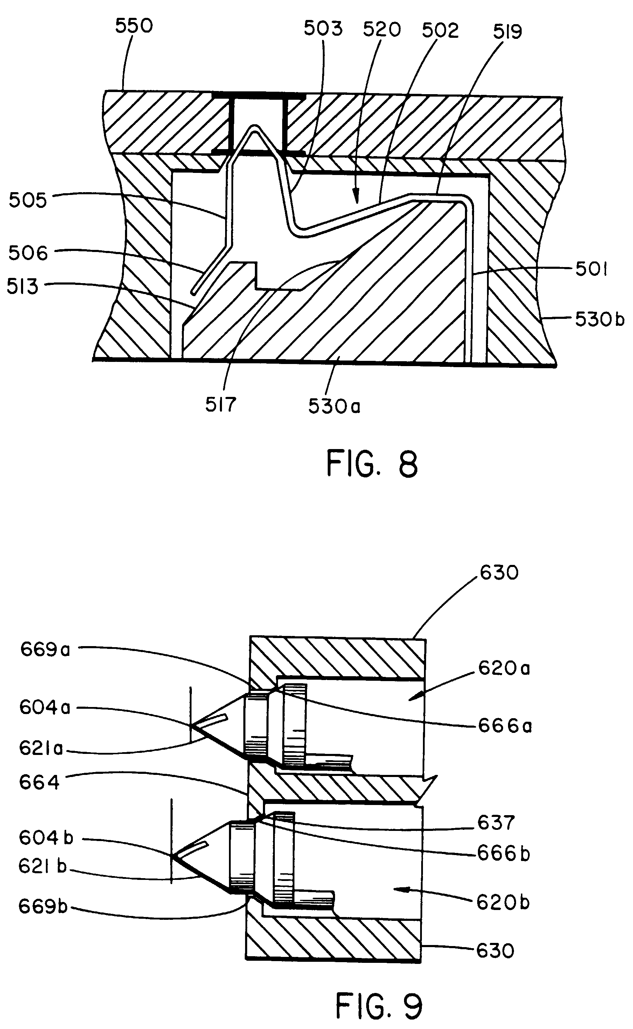

Another wire formed contact element 520 is seen in Fig. 8. In the embodiment of Fig. 8, the housing 530a may be used as a mandrel on which the spring contact 520 is at least partially formed. The wire formed spring contact element 520 includes segments 501, 502, 503, 505, and 506, with segments 503, 505, and 506 preferably preformed. Segment 501 acts as the tail segment and is held in place by housing portions 530a and 503b. In forming the contact element, as indicated in Fig. 8, segment 502 is bent around housing 530a at about ninety degrees relative to segment 501. Then, segment 502 is held against the housing 530a at point 519 and overbent along ramp 517 while segment 506 engages ramp 513 of housing 530a. Upon releasing the contact element at point 519, segment 502 springs back into the position as shown in Fig. 8, while segment 506 disengages ramp 513. With segments 503, 505, and 506 already preformed, the wire formed tapered spring contact element 520 can be used to engage the rim of a hole of a PCB 550 or the like. Upon engaging the rim of a hole, portions 502, 503, 505 and 506 of the spring contact element are forced backward. As a result, portion 506 of the spring contact element 521 engages ramp 513, and portions 505 and 503 are spread relative to each other, thereby enhancing contact and mating.

If desired, the connector of Fig. 8 may have a second section which is the mirror image of that shown. In this manner, board to board connection may be made without having any fixed connections.

Because of the tolerances available with the mating of a tapered contact element with a rim of a hole, connectors utilizing such a mating scheme can be readily provided with various first mate (make), last break arrangements. For example, as seen in Fig. 9, a connector is shown with a first contact element 620a having bifurcated conical contact portion 621a, and a second contact element 620b having bifurcated conical contact portion 621b. In accord with the embodiment of Fig. 3b, each contact element has an angled surface 637 for centering and spring loading purposes. Also, the housing 630 for the contact elements includes similarly angled surfaces 666a, and 666b for engaging angled surfaces 637. However, in order to provide a first make, last break arrangement, the angled surfaces 666a and 666b of the housing 630 are not identical. As shown in Fig. 9, angled surface 666b is molded closer to the front face 664 of the housing 630 than is angled surface 666a. This difference is more easily seen by comparing the length of opening surfaces 669a and 669b. As a result of this difference, the contact portion 621a of spring contact element 620a does not extend out of the housing as far as the contact portion 621b of spring contact element 620b; i.e. the tip 604b of contact portion 621b extends further than tip 604a of contact portion 621a. Thus, when mating with rims of a flat surface, contact portion 621b will be the first to mate. When disconnecting, contact portion 621b will be the last to break.

It should be appreciated that other housing arrangements will also provide the first to make, last to break function. For example, instead of changing the location of the angled surface 666 of the housing in which the first to mate contact is housed, that angled surface may be left in the same location but slightly enlarged. Thus, the contact portion 621 of that spring contact element will have to extend further out of the housing before its angled surface 637 engages the angled surface 666 of the housing. Such an arrangement has the advantage that the first to mate contact may be chosen after the connector has been molded, as the angled surface is enlarged via the removal of material. Regardless of the scheme chosen, it should be understood that by varying the housing either during manufacture or thereafter, any particular contact or plurality of contacts may be chosen to provide the first to mate, last to break function. In fact, sequencing can be accomplished in the mating procedure by changing or altering the housing in a plurality of increments.

The first to make, last to break function may also be made by providing a certain spring element with a slightly smaller sized contact portion such that it extends further out of the housing than the contact portions of the other spring elements.

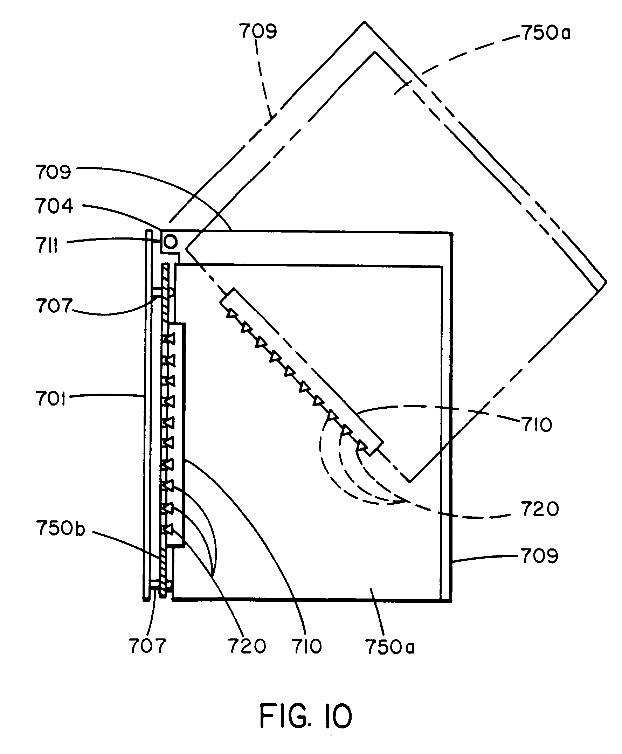

Another first to make, last to break arrangement for a tapered contact element connector is seen in Fig. 10 where the particular contact element making first contact is fixed due to geometry. A first circuit board 750a is shown having attached thereto a tapered spring contact element connector 710 with a plurality of contact elements 720. Housing the first circuit board 750a is an open or enclosed modular housing 709 which includes a key slot 711 for pivoting purposes. The connector 710 is provided for connecting the first circuit board 750a to a second parallel or perpendicular circuit board 750b which has holes with conductive rims. The second circuit board 750b as shown is a backplane which is mounted on a rear panel 701 via screws 707. Preferably as part of the backplane 750b, a pivot means 704 is provided around which the key slot 711 fits. Board 750a may then be rotated relative to board 750b such that connector 710 will mate with the conductive rims of board 750b. Because of the rotation, if the contact elements 720 of connector 710 and the rims of the second circuit board 750b are uniform, the contact element 720 closest to the pivot 704 will make first contact upon mating, and break last upon separation. In fact, the contact elements 720 will mate and break in a natural sequence. Of course, the first make, last break function can be accomplished with the embodiment of Fig. 10 even if the contact elements 720 or the housing 730 are not uniform.

The embodiment of Fig. 10 is useful in mating a printed circuit board to a backplane. It is also useful in mating two circuit boards, in mating a cable to a circuit board, in mating two cables, etc.

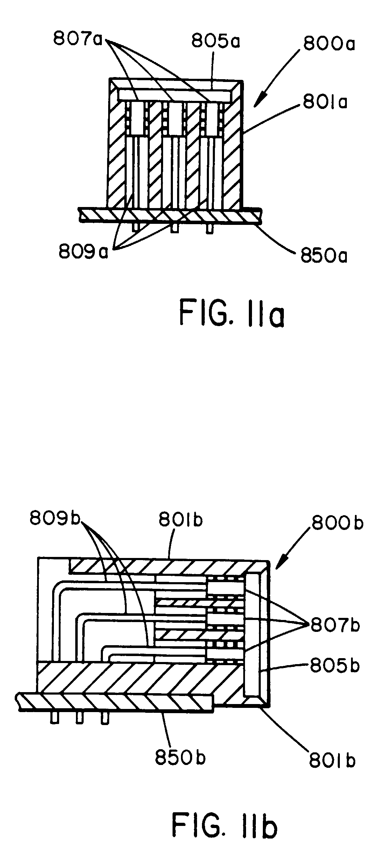

While the connector invention disclosed herein is effective in removing the need for two connector parts, it will be appreciated that in some situations, it may be desirable to provide a mating female connector part for the male connector which has the tapered spring contact elements. Two embodiments of such a female connector are seen in Figs. 11a and 11b. In Fig. 11a, a straight through female connector 800a is seen with a housing 801a. The female connector 800a has a recessed entry area 805a, a plurality of holes 807a (preferably with straight sides) having plated rims, and a plurality of conductor elements 809a electrically coupling the plated rims to a circuit board 850a. As shown in Fig. 11a, the tail portion of the conductor elements 809a are press fit and/or soldered to the circuit board 850a. However, it should be appreciated that the tail portion of the conductor elements 809a can take other forms such as an insulation displacement tail, a surface mount tail, or a wire crimp tail, which can be used for connection to one or more of a board, a wire, a ribbon cable, or a flex-circuit.

The female connector 800b of Fig. 11b is very similar to that of connector 800a, except that the conductor elements 809b traverse approximately ninety degrees in coupling the plated rims to the board 850b, and the housing 801b is changed to accommodate the same.

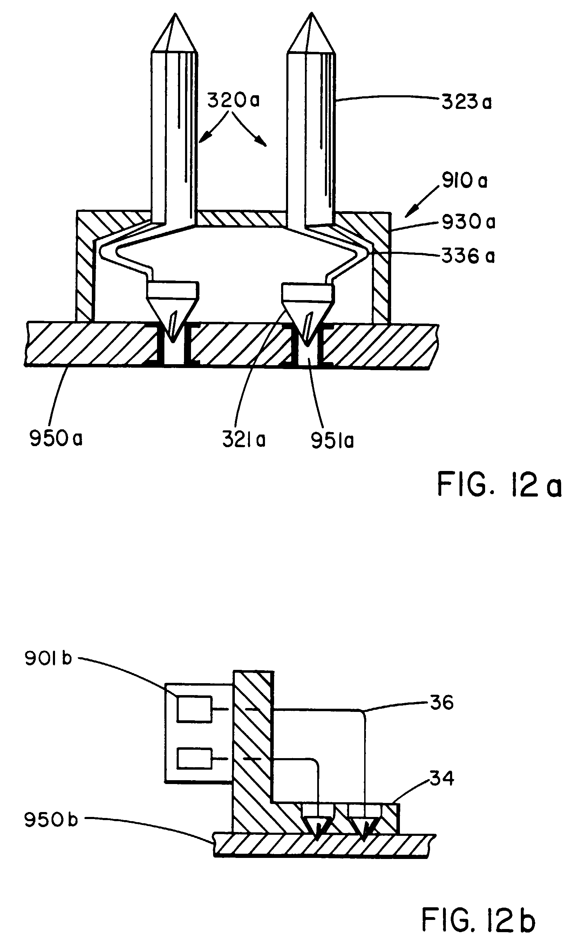

While the connector of the invention utilizing spring contact elements with tapered end portions is applied advantageously to connectors which are removable and reattachable, it should be appreciated that the teachings contained herein may further be used for permanent non-solder connections. As seen in Fig. 12a, a permanent non-solder connection is made between a PCB 950a and a pin- or post-header type connector 910a having spring contact elements 320a such as previously described with reference to Fig. 6a (with contact portion 321a, spring portion 336a, and tail 323a). The housing 930a of the connector 900a may be permanently joined to the PCB board 950a via any type of means (not shown) or method such that the tapered contact portions 321a of the spring contact elements 320a are fixed in the holes 951a of the PCB board 950a. With such an arrangement, a base metal system (e.g. tin-lead) for the contact portions 321a and the rims of the holes 951a is believed adequate for proper connection. In fact, it is believed that even for the nonpermanent connectors disclosed above with reference to Figs. 1-11, a base metal system may be suitable as it is believed that fret corrosion is substantially reduced and possibly eliminated with the tapered contact to hole rim connection provided according to the invention.

A right angle permanent socket type connector is shown in Fig. 12b, which is similar in several ways to the connector of Fig. 12a. However, instead of using the contact elements of Fig. 6a, the contact elements 20 of Fig. 1 are used in the connector of Fig. 12b. Also, instead of the pins 323a, a female contact portion 901b is provided. Contact elements 20 have their tapered portion 34 in permanent contact with the holes 951b of PCB board 950b. As shown in Fig. 12b, the female contact portion 901b is substantially in the format of the female connector 800a of Fig. 11a. Of course, with the connectors of Figs. 12a and 12b, any tail geometry or spring geometry such as shown in Figs. 5a-5f and 6a-6d could be utilized. The spring tip of Figs. 7a and 7b could likewise be utilized.

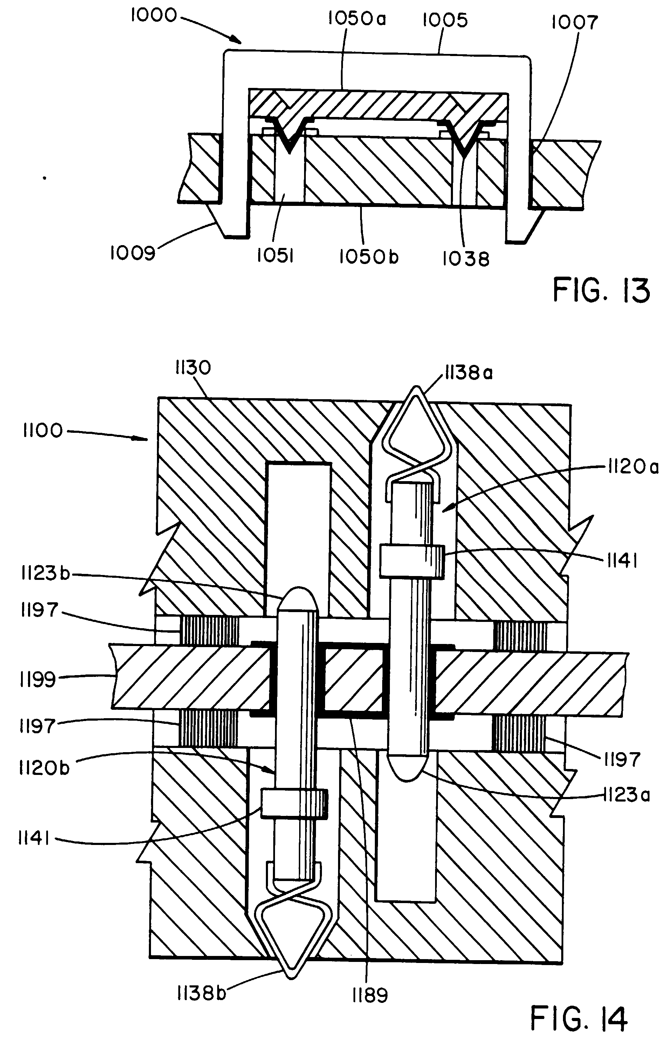

Turning to Fig. 13, a flex print to board connector 1000 according to the concepts of the invention is seen. The flex print 1050a is embossed with a conductive tapered contact portions 1038 which are designed to mate with the conductive rims of holes 1051 in board 1050b. A one piece preformed plastic bent beam spring 1005 is provided to hold the flex print 1050a down on the board 1050b, and hence the contact portions 1038 in engagement with the rims of the holes 1051. Board 1050b is also provided with mating holes 1007 for permitting legs 1009 on the bent beam spring 1005 to extend through and grab the board 1050b.

The connector 1100 of Fig. 14 is useful for board to board applications where different board to board distances are accommodated. Connector 1100 is shown with housing 1130, contact elements 1120a and 1120b having tail portions 1123a and 1123 extending through an intermediate board 1199, and a shim 1197. Contact elements 1120a and 1120b are wire formed tapered contact elements as described in Serial No. (Docket GDC-030CIP1) with a tapered spring contact end 1138, a stop 1141, and a tail 1123. The tails 1123 may be press fit into board 1199 to provide a desired effective length of the contact elements. Thus, with the connector embodiment of Fig. 14, only one length contact element need be manufactured, as various board-to-board distances may be accommodated. As shown in Fig. 14, shims 1197 are provided to support the housing, and different size shims would be utilized depending upon how far into board 1199, the tails 1123 of contact elements 1120 would be forced. Also, as shown in Fig. 14, conductive paths 1189 are provided between two contact elements 1120a and 1120b where desired.

It should be appreciated that the variable distance connector 1100 of Fig. 14 could be utilized where intermediate board 1199 acts as the second circuit board, and one side of the connector is fixed; i.e. the press fit side is fixed into the circuit board 1199. In such an application, the contact element 1120a provides the conductive path between the boards, and conductive paths between contact elements such as shown as 1189 would not be required.

There has been disclosed herein connectors utilizing tapered spring contact elements for mating with plated rims of an object. While particular embodiments of the invention have been described, it is not intended that the invention be limited thereby, as it is intended that the invention be broad in scope and that the specifications be read likewise. Thus, while board to board, cable to board, board to cable, cable to cable, and other embodiments and applications (e.g. board to wire, surface mount, etc.) have been described, it will be appreciated that the tapered spring contact element connector concept can be used in a multitude of applications, including, but not limited to: terminals; splices; plugs and receptacles; quick connect/disconnect; rack and panel; card edge; pin and socket; mass termination; jumpers; zero insertion force; power terminals; headers; sockets; hermaphroditic; input/output; RF shielded; and terminal blocks. To accommodate different types of connectors, spring elements, housings, and fastening means other than those disclosed, but obvious to those skilled in the art could be utilized.

## Claims

1. An electrical connector for mating with conductive rims (51) of holes of a circuit board (50), the electrical connector comprising a plurality of contact element means (20) and a housing (30) which houses the plurality of contact element means, each contact element means having a tapered contact portion (38) for mating with one of the conductive rims of the circuit board, said tapered contact portion being tapered along an axis of its contact element means, and a spring portion (36) which is coupled to the tapered contact portion (38), makes electrical contact with a conductor means other than said circuit board with which the tapered contact portion makes contact, and urges the tapered contact portion (38) along its said axis, characterized in that each contact element means (20) is laterally tolerant for permitting said tapered contact portion (38) to move in said housing (30) in a direction which is lateral with respect to said axis of its contact element means so as to seat in the conductive rim (51) of the hole in the circuit board (50) with which it mates, and said electrical connector further comprises fastening means for fastening said electrical connector to the circuit board (50) to keep said plurality of tapered contact portions (38) mated with said conductive rims (51).

2. An electrical connector according to claim 1, characterized in that said spring portion of each said contact element means includes a spring element and a contact element (223).

3. An electrical connector according to claim 1 or 2, characterized in that said spring portion includes means (323b) for contacting conductive pads on a surface mount board.

4. An electrical connector according to claim 2, for connecting said board to a second board having second conductive rims, the connector being characterized by a plurality of second contact element means (1120), each second contact element means having a spring portion (1138) which makes electrical contact with said conductor means, each second contact element means having a tapered contact portion coupled to said spring portion of said second contact element means for mating with one of said conductive rims of said second board, and said housing comprising a spacer means (1199) containing said conductor means.

5. An electrical connector according to claim 4, characterized in that said spacer means (1199) comprises a dielectric piece having a plurality of first surface conductive means (1189) on one surface of said dielectric piece, a plurality of second surface conductive means (1189) on an opposite surface of said dielectric piece, and a plurality of conductive connective means (1189) for connecting a plurality of first and second surface conductive means.

6. An electrical connector according to claim 1 or 2, characterized in that said conductor means comprises a ribbon cable (350i) with a plurality of conductors, and in that each spring portion terminates in an insulation stripping tail means (323i) for making contact with a conductor of the ribbon cable.

7. An electrical connector according to claim 6, characterized by clamp means (314i) for cooperating with said insulation stripping tail means for making contact with a conductor of said ribbon cable.

8. An electrical connector according to any previous claim, characterized in that each of said plurality of contact element means is a wire formed tapered contact portion (421) for mating with one of said conductive rims of said board, said wire formed tapered contact portion being axially and/or radially compliant.

9. An electrical connector according to claim 8, characterized in that each said contact element means has a post (409), said wire formed tapered contact portion being coupled to said post, and each post being coupled to conductive means other than said conductive rims of said holes of said board.

10. An electrical connector according to claim 9, characterized in that said wire formed tapered contact portion comprises a single wire extending vertically from said post and having five bends, with a first bend of approximately one hundred and twenty degrees, a second bend of approximately ninety degrees, a third bend of approximately of approximately sixty degrees, a fourth bend of approximately ninety degrees, and a fifth bend of approximately one hundred twenty degrees.

11. An electrical connector according to claim 10 for connecting said circuit board to a second board having second conductive rims, the connector being characterized by a plurality of second contact element means, each second contact element means having a wire formed tapered contact portion for mating with one of said second conductive rims of said second board, said wire formed tapered contact portion being both axially and radially compliant.

12. An electrical connector according to claim 2, for providing a semipermanent electrical connection between the conductive rims of holes of said first circuit board and the conductive rims of holes of a second object, said first circuit board and said second object being substantially parallel to each other, the connector being characterized in that each spring portion of each contact element has a second tapered contact portion (223) for mating with a conductive rim of a said hole of said second object, and said housing comprises a front wall which is substantially parallel to said first board when said electrical connector mates with said first board, said front wall having a plurality of first apertures for permitting at least a portion of said first tapered contact portions to extend therethrough.

13. An electrical connector according to claim 12, characterized in that said housing comprises a rear wall which is substantially parallel to said second object when said electrical connector mates with said second object, said rear wall having a plurality of second apertures for permitting at least a portion of said second tapered contact portions to extend therethrough.

14. An electrical connector according to claim 13, characterized in that said first and second apertures in said front and rear walls are shaped (66) for causing said first and second tapered contact portions to contact said apertures to stop said contact element means in desired locations such that said contact element means are preloaded.

15. An electrical connector according to any previous claim, characterized in that said spring portion (236) is one of a u-shaped (236a,236d,236e), a z-shaped (236b), or a s-shaped (236C,236F) spring.

16. An electrical connector according to any previous claim, characterized in that said contact portions are bifurcated cones (321).

17. An electrical connector according to any previous claim, characterized by first make, last break means for causing a particular one of said plurality of contact element means to contact a particular conductive rim before others of said plurality of contact element means contact others of said conductive rims.

18. An electrical connector according to claim 17, characterized in that said electrical connector includes a dielectric housing (630) with a plurality of apertures (669) and said first make, last break means comprises a particular aperture (669b) of said plurality of apertures which is configured differently from others of said plurality of apertures (669a) such that a particular contact element means (620h) having its tapered contact portion (621b) extending through said particular aperture has its tapered contact portion extending out of said dielectric housing (630) further than said others of said plurality of contact element means (620a) which have their tapered contact portions (621a) extending through said others of said plurality of apertures.

19. An electrical connector according to claim 17, characterized in that said first make, last break means comprises a hinge (711) allowing relative rotational movement between said electrical connector (710) and said board (750b).

## Patentansprüche

1. Elektrischer Verbinder zum Zusammenstecken mit leitenden Rändern (51) von Löchern einer Leiterplatte (50), wobei der elektrische Verbinder folgendes umfaßt: mehrere Kontaktelementmittel (20) und ein Gehäuse (30), das die mehreren Kontaktelementmittel beherbergt, wobei jedes Kontaktelementmittel einen konischen Kontaktabschnitt (38) zum Zusammenstecken mit einem der leitenden Ränder der Leiterplatte aufweist, wobei der konische Kontaktabschnitt sich entlang einer Achse seines Kontaktelementmittels verjüngt, und einen Federabschnitt (36), der an den konischen Kontaktabschnitt (38) angekoppelt ist, mit einem von der Leiterplatte, die der konische Kontaktabschnitt kontaktiert, verschiedenen Leitermittel einen elektrischen Kontakt herstellt und den konischen Kontaktabschnitt (38) entlang seiner Achse drängt, dadurch gekennzeichnet, daß jedes Kontaktelementmittel (20) seitliche Toleranz aufweist, damit sich der konische Kontaktabschnitt (38) in dem Gehäuse (30) in einer Richtung bewegen kann, die bezüglich der Achse seines Kontaktelementmittels seitlich ist, um in dem leitenden Rand (51) des Lochs in der Leiterplatte (50) zu sitzen, mit dem er zusammengesteckt ist, und wobei der elektrische Verbinder weiterhin ein Befestigungsmittel zum Befestigen des elektrischen Verbinders an der Leiterplatte (50) umfaßt, um die mehreren konischen Kontaktabschnitte (38) mit den leitenden Rändern (51) zusammengesteckt zu halten.

2. Elektrischer Verbinder nach Anspruch 1, dadurch gekennzeichnet, daß der Federabschnitt jedes Kontaktelementmittels ein Federelement und ein Kontaktelement (223) enthält.

3. Elektrischer Verbinder nach Anspruch 1 oder 2, dadurch gekennzeichnet, daß der Federabschnitt ein Mittel (323b) zum Kontaktieren von leitenden Inseln auf einer Leiterplatte für Oberflächenmontage enthält.

4. Elektrischer Verbinder nach Anspruch 2 zum Verbinden der Leiterplatte mit einer zweiten Leiterplatte mit zweiten leitenden Rändern, wobei der Verbinder durch mehrere zweite Kontaktelementmittel (1120), wobei jedes zweite Kontaktelementmittel einen Federabschnitt (1138) aufweist, der mit dem Leitermittel einen elektrischen Kontakt herstellt, wobei jedes zweite Kontaktelementmittel einen an den Federabschnitt des zweiten Kontaktelementmittels angekoppelten konischen Kontaktabschnitt zum Zusammenstecken mit einem der leitenden Ränder der zweiten Leiterplatte aufweist, gekennzeichnet ist und wobei das Gehäuse ein das Leitermittel enthaltendes Abstandshaltermittel (1199) umfaßt.

5. Elektrischer Verbinder nach Anspruch 4, dadurch gekennzeichnet, daß das Abstandshaltermittel (1199) ein dielektrisches Stück mit mehreren ersten, an der Oberfläche leitenden Mitteln (1189) an einer Oberfläche des dielektrischen Stücks, mehreren zweiten, an der Oberfläche leitenden Mitteln (1189) an einer entgegengesetzten Oberfläche des dielektrischen Stücks und mehrere leitende Verbindungsmittel (1189) zum Verbinden mehrerer erster und zweiter, an der Oberfläche leitender Mittel umfaßt.

6. Elektrischer Verbinder nach Anspruch 1 oder 2, dadurch gekennzeichnet, daß das Leitermittel ein Flachkabel (350i) mit mehreren Leitern umfaßt und daß jeder Federabschnitt in einem abisolierenden Hinterende (323i) zum Kontaktieren eines Leiters des Flachkabels endet.

7. Elektrischer Verbinder nach Anspruch 6, gekennzeichnet durch ein Klemmittel (314i) zum Zusammenwirken mit dem abisolierenden Hinterende zum Kontaktieren eines Leiters des Flachkabels.

8. Elektrischer Verbinder nach einem der vorhergehenden Ansprüche, dadurch gekennzeichnet, daß jedes der mehreren Kontaktelementmittel ein aus Draht gebildeter konischer Kontaktabschnitt (421) zum Zusammenstecken mit einem der leitenden Ränder der Leiterplatte ist, wobei der aus Draht gebildete konische Kontaktabschnitt axial und/oder radial nachgiebig ist.

9. Elektrischer Verbinder nach Anspruch 8, dadurch gekennzeichnet, daß jedes Kontaktelementmittel einen Pfosten (409) aufweist, wobei der aus Draht gebildete konische Kontaktabschnitt an den Pfosten angekoppelt ist, und jeder Pfosten an ein leitendes Mittel angekoppelt ist, aber nicht an die leitenden Ränder der Löcher der Leiterplatte.

10. Elektrischer Verbinder nach Anspruch 9, dadurch gekennzeichnet, daß der aus Draht gebildete konische Kontaktabschnitt einen einzelnen Draht umfaßt, der sich von dem Pfosten aus vertikal erstreckt und fünf Biegungen aufweist, mit einer ersten Biegung von etwa einhundertzwanzig Grad, einer zweiten Biegung von etwa neunzig Grad, einer dritten Biegung von etwa sechzig Grad, einer vierten Biegung von etwa neunzig Grad und einer fünften Biegung von etwa einhundertzwanzig Grad.

11. Elektrischer Verbinder nach Anspruch 10 zum Verbinden der Leiterplatte mit einer zweiten Leiterplatte mit zweiten leitenden Rändern, wobei der Verbinder durch mehrere zweite Kontaktelementmittel, wobei jedes zweite Kontaktelementmittel einen aus Draht gebildeten konischen Kontaktabschnitt zum Zusammenstecken mit einem der zweiten leitenden Ränder der zweiten Leiterplatte aufweist, wobei der aus Draht gebildete konische Kontaktabschnitt sowohl axial als auch radial nachgiebig ist, gekennzeichnet ist.

12. Elektrischer Verbinder nach Anspruch 2 zum Bereitstellen einer halbpermanenten elektrischen Verbindung zwischen den leitenden Rändern von Löchern der ersten Leiterplatte und den leitenden Rändern von Löchern eines zweiten Gegenstands, wobei die erste Leiterplatte und der zweite Gegenstand im wesentlichen parallel zueinander sind, wobei der Verbinder dadurch gekennzeichnet ist, daß jeder Federabschnitt jedes Kontaktelements einen zweiten konischen Kontaktabschnitt (223) zum Zusammenstecken mit einem leitenden Rand eines Lochs des zweiten Gegenstands aufweist und das Gehäuse eine Vorderwand umfaßt, die im wesentlichen parallel zu der ersten Leiterplatte verläuft, wenn der elektrische Verbinder mit der ersten Leiterplatte zusammengesteckt wird, wobei die Vorderwand mehrere erste Aperturen aufweist, damit wenigstens ein Teil der ersten konischen Kontaktabschnitte sich dort hindurch erstrecken kann.

13. Elektrischer Verbinder nach Anspruch 12, dadurch gekennzeichnet, daß das Gehäuse eine Rückwand umfaßt, die im wesentlichen parallel zu dem zweiten Gegenstand verläuft, wenn der elektrische Verbinder mit dem zweiten Gegenstand zusammengesteckt wird, wobei die Rückwand mehrere zweite Aperturen aufweist, damit wenigstens ein Teil der zweiten konischen Kontaktabschnitte sich dort hindurch erstrecken kann.

14. Elektrischer Verbinder nach Anspruch 13, dadurch gekennzeichnet, daß die ersten und zweiten Aperturen in der Vorder- und Rückwand geformt sind (66), um zu bewirken, daß der erste und der zweite konische Kontaktabschnitt die Aperturen kontaktieren, um die Kontaktelementmittel an gewünschten Stellen anzuhalten, so daß die Kontaktelementmittel vorbelastet sind.

15. Elektrischer Verbinder nach einem der vorhergehenden Ansprüche, dadurch gekennzeichnet, daß der Federabschnitt (236) einer einer u-förmigen (236a, 236d, 236e), einer z-förmigen (236b) oder einer s-förmigen (236C, 236F) Feder ist.

16. Elektrischer Verbinder nach einem der vorhergehenden Ansprüche, dadurch gekennzeichnet, daß die Kontaktabschnitte gegabelte Kegel (321) sind.

17. Elektrischer Verbinder nach einem der vorhergehenden Ansprüche, gekennzeichnet durch ein voreilendes/nacheilendes Mittel, um zu bewirken, daß ein bestimmtes der mehreren Kontaktelementmittel einen bestimmten leitenden Rand kontaktiert, ehe andere der mehreren Kontaktelementmittel andere der leitenden Ränder kontaktieren.

18. Elektrischer Verbinder nach Anspruch 17, dadurch gekennzeichnet, daß der elektrische Verbinder ein dielektrisches Gehäuse (630) mit mehreren Aperturen (669) enthält und das voreilende/nacheilende Mittel eine bestimmte Apertur (669b) der mehreren Aperturen umfaßt, die von anderen der mehreren Aperturen (669a) unterschiedlich konfiguriert ist, so daß ein bestimmtes Kontaktelementmittel (620h), dessen konischer Kontaktabschnitt (621b) sich durch die bestimmte Apertur erstreckt, sich mit seinem konischen Kontaktabschnitt weiter aus dem dielektrischen Gehäuse (630) erstreckt als die anderen der mehreren Kontaktelementmittel (620a), deren konische Kontaktabschnitte (621a) sich durch die anderen der mehreren Aperturen erstrecken.

19. Elektrischer Verbinder nach Anspruch 17, dadurch gekennzeichnet, daß das voreilende/nacheilende Mittel ein Gelenk (711) umfaßt, das zwischen dem elektrischen Verbinder (710) und der Leiterplatte (750b) eine relative Drehbewegung gestattet.

## Revendications

1. Connecteur électrique destiné à s'accoupler avec des rebords conducteurs (51) de trous d'une carte imprimée (50), le connecteur électrique comprenant une pluralité de moyens à élément de contact (20) et un boîtier (30) dans lequel sont logés la pluralité de moyens à élément de contact, chaque moyen à élément de contact possédant une partie de contact conique (38) destinée à s'accoupler avec l'un des rebords conducteurs de la carte imprimée, ladite partie de contact conique étant conique le long d'un axe de son moyen à élément de contact, et une partie de ressort (36) qui est couplée à la partie de contact conique (38), établit un contact électrique avec un moyen conducteur autre que ladite carte imprimée au contact de laquelle vient la partie de contact conique, et pousse la partie de contact conique (38) le long de son dit axe, caractérisé en ce que chaque moyen à élément de contact (20) présente une tolérance latérale pour permettre le mouvement de ladite partie de contact conique (38) dans ledit boîtier (30), dans une direction latérale par rapport audit axe de son moyen à élément de contact de manière à se caler dans le rebord conducteur (51) du trou dans la carte imprimée (50) avec lequel il s'accouple, et ledit connecteur électrique comprend en outre un moyen de fixation pour fixer ledit connecteur électrique à la carte imprimée (50) pour maintenir ladite pluralité de parties de contact coniques (38) accouplées avec lesdits rebords conducteurs (51).

2. Connecteur électrique selon la revendication 1, caractérisé en ce que ladite partie de ressort de chaque dit moyen à élément de contact comporte un élément de ressort et un élément de contact (223).

3. Connecteur électrique selon la revendication 1 ou 2, caractérisé en ce que ladite partie de ressort comporte un moyen (323b) pour venir au contact de plages de connexion conductrices sur une carte à montage en surface.

4. Connecteur électrique selon la revendication 2, destiné à connecter ladite carte à une deuxième carte présentant des deuxièmes rebords conducteurs, le connecteur étant caractérisé par une pluralité de deuxièmes moyens à élément de contact (1120), chaque deuxième moyen à élément de contact possédant une partie de ressort (1138) qui établit un contact électrique avec ledit moyen conducteur, chaque deuxième moyen à élément de contact possédant une partie de contact conique couplée à ladite partie de ressort dudit deuxième moyen à élément de contact pour s'accoupler avec l'un desdits rebords conducteurs de ladite deuxième carte, et ledit boîtier comprenant un moyen écarteur (1199) contenant ledit moyen conducteur.

5. Connecteur électrique selon la revendication 4, caractérisé en ce que ledit moyen écarteur (1199) comprend une pièce diélectrique présentant une pluralité de premiers moyens conducteurs superficiels (1189) sur une surface de ladite pièce diélectrique, une pluralité de deuxièmes moyens conducteurs superficiels (1189) sur une surface opposée de ladite pièce diélectrique, et une pluralité de moyens connecteurs conducteurs (1189) destinés à connecter une pluralité de premiers et deuxièmes moyens conducteurs superficiels.

6. Connecteur électrique selon la revendication 1 ou 2, caractérisé en ce que ledit moyen conducteur comprend un câble à ruban (350i) avec une pluralité de conducteurs, et en ce que chaque partie de ressort se termine par un moyen de queue à dénuder (323i) pour établir un contact avec un conducteur du câble à ruban.

7. Connecteur électrique selon la revendication 6, caractérisé par un moyen de serrage (314i) destiné à coopérer avec ledit moyen de queue à dénuder pour établir un contact avec un conducteur dudit câble à ruban.

8. Connecteur électrique selon l'une quelconque des revendications précédentes, caractérisé en ce que chacun de ladite pluralité de moyens à élément de contact est une partie de contact conique (421) sous forme de fil destinée à s'accoupler avec l'un desdits rebords conducteurs de ladite carte, ladite partie de contact conique sous forme de fil étant déformable axialement et/ou radialement.

9. Connecteur électrique selon la revendication 8, caractérisé en ce que chaque dit moyen à élément de contact possède une borne (409), ladite partie de contact conique sous forme de fil étant couplée à ladite borne, et chaque borne étant couplée à un moyen conducteur autre que lesdits rebords conducteurs desdits trous de ladite carte.

10. Connecteur électrique selon la revendication 9, caractérisé en ce que ladite partie de contact conique sous forme de fil comprend un fil unique s'étendant verticalement depuis ladite borne et présentant cinq coudes, avec un premier coude d'approximativement cent vingt degrés, un deuxième coude d'approximativement quatre-vingt-dix degrés, un troisième coude d'approximativement soixante degrés, un quatrième coude d'approximativement quatre-vingt-dix degrés et un cinquième coude d'approximativement cent vingt degrés.

11. Connecteur électrique selon la revendication 10, destiné à connecter ladite carte imprimée à une deuxième carte présentant des deuxièmes rebords conducteurs, le connecteur étant caractérisé par une pluralité de deuxièmes moyens à élément de contact, chaque deuxième moyen à élément de contact possédant une partie de contact conique sous forme de fil destinée à s'accoupler avec l'un desdits deuxièmes rebords conducteurs de ladite deuxième carte, ladite partie de contact conique sous forme de fil étant déformable aussi bien axialement que radialement.

12. Connecteur électrique selon la revendication 2, destiné à procurer une connexion électrique semi-permanente entre les rebords conducteurs de trous de ladite première carte imprimée et les rebords conducteurs de trous d'un deuxième objet, ladite première carte imprimée et ledit deuxième objet étant essentiellement parallèles l'un à l'autre, le connecteur étant caractérisé en ce que chaque partie de ressort de chaque moyen à élément de contact possède une deuxième partie de contact conique (223) destinée à s'accoupler à un rebord conducteur d'un dit trou dudit deuxième objet, et ledit boîtier comprend une paroi avant essentiellement parallèle à ladite première carte lorsque ledit connecteur électrique est accouplé avec ladite première carte, ladite paroi avant présentant une pluralité de premières ouvertures pour permettre l'extension à travers elle d'au moins une partie desdites premières parties de contact coniques.

13. Connecteur électrique selon la revendication 12, caractérisé en ce que ledit boîtier comprend une paroi arrière essentiellement parallèle audit deuxième objet lorsque ledit connecteur électrique est accouplé avec ledit deuxième objet, ladite paroi arrière présentant une pluralité de deuxièmes ouvertures pour permettre l'extension à travers elle d'au moins une partie desdites deuxièmes parties de contacts coniques.

14. Connecteur électrique selon la revendication 13, caractérisé en ce que lesdites premières et deuxièmes ouvertures dans lesdites parois avant et arrière sont formées (66) de façon à amener lesdites premières et deuxièmes parties coniques au contact desdites ouvertures pour immobiliser lesdits moyens à élément de contact dans des emplacements souhaités de sorte que lesdits moyens à élément de contact soient précomprimés.

15. Connecteur électrique selon l'une quelconque des revendications précédentes, caractérisé en ce que ladite partie de ressort (236) est une partie d'un ressort en forme de u (236a, 236d, 236e), en forme de z (236b) ou en forme de s (236c, 236f).

16. Connecteur électrique selon l'une quelconque des revendications précédentes, caractérisé en ce que lesdites parties de contact sont des cônes fendus (321).

17. Connecteur électrique selon l'une quelconque des revendications précédentes, caractérisé par un moyen "first make/last break" destiné à amener un moyen particulier parmi ladite pluralité de moyens à élément de contact à venir au contact d'un rebord conducteur particulier avant que d'autres de ladite pluralité de moyens à élément de contact viennent au contact d'autres desdits rebords conducteurs.

18. Connecteur électrique selon la revendication 17, caractérisé en ce que ledit connecteur électrique comporte un boîtier diélectrique (630) avec une pluralité d'ouvertures (669) et ledit moyen "first make/last break" comprend une ouverture particulière (669b) de ladite pluralité d'ouvertures configurée différemment des autres de ladite pluralité d'ouvertures (669a) de façon à ce qu'un moyen à élément de contact particulier (620h) dont la partie de contact conique (621b) s'étend à travers ladite ouverture particulière soit tel que sa partie de contact conique s'étend hors dudit boîtier diélectrique (630) davantage que lesdits autres de ladite pluralité de moyens à élément de contact (620a) dont les parties de contact coniques (621a) s'étendent à travers lesdites autres de ladite pluralité d'ouvertures.

19. Connecteur électrique selon la revendication 17, caractérisé en ce que ledit moyen "first make/last break" comprend une charnière (711) permettant le mouvement relatif en rotation entre ledit connecteur électrique (710) et ladite carte (750b).
